# EUROPEAN PATENT SPECIFICATION

(11) **EP 2 065 283 B1**
(45) Date of publication and mention of the grant of the patent: **23.07.2014**
(21) Application number: 07790235.1
(22) Date of filing: 29.06.2007
(51) Int. Cl.: B61C 17/00, H01L 23/467, H05K 7/20

(54) **COOLING DEVICE FOR MOBILE BODY**
KÜHLVORRICHTUNG FÜR MOBILEN KÖRPER
DISPOSITIF DE REFROIDISSEMENT POUR UN CORPS MOBILE

(30) Priority: 19.09.2006 JP 2006252005
(43) Date of publication of application: 03.06.2009
(73) Proprietor: Mitsubishi Electric Corporation, Chiyoda-ku Tokyo 100-8310 (JP)
(72) Inventor: ISHIDA, Takahito, Tokyo; 100-8310 (JP)
(74) Representative: Sajda, Wolf E.
(86) International application number: PCT/JP2007/000715
(87) International publication number: WO 2008/035452

(56) References cited:
- JP-A- 6 064 533
- JP-A- 7 221 229
- JP-A- 06 064 533
- JP-A- 54 047 217
- JP-A- 57 096 558
- JP-A- 2001 332 883
- JP-A- 2004 014 612
- JP-A- 2004 186 702

## Description

### TECHNICAL FIELD

The present invention relates to a moving body cooling apparatus for cooling a heat-generating element like a semiconductor device mounted on a moving body, such as a railroad car. More particularly, the invention pertains to a moving body cooling apparatus which utilizes relative wind (traveling wind) produced as a moving body is running.

### BACKGROUND ART

A conventional moving body cooling apparatus for cooling a heat-generating element like a semiconductor device mounted on a moving body, such as a railroad car, is configured such that cooling fins for dissipating heat generated by the semiconductor device are arranged parallel to a moving direction of the car (refer to Patent Document 1, for example).

Patent Document 1: Japanese Laid-open Patent Application JP-A-2003-258 471 (paragraph[0025] and FIG. 1)

In JP-A-06 064 533, a liner motor is disclosed into which air flows into an intermediate air region between a floor plate and a bottom plate through a through hole formed on a horizontal beam on a front side in an advance direction. A dolly is provided and the air is discharged outside through a through hole on a rear side horizontal beam 2b, ensuring the dolly is not heated.

JP-A-57-096 558 discloses that air holes are formed to an upper section and a lower section of a side wall and a top wall of a cubicle. Cooling radiators, to which rectifying elements are mounted are arranged in such a manner that radiation fins are each opposed, paired in the horizontal direction, faced one another at the same interval, and also stacked at every each row at the same interval in the vertical direction. The mounting plates of accessory circuits are inclined to an oblique upper section from the upper outside edges of each cooling radiator and attached: The upper end edges are opposed, and space sections are formed among the mutual upper end edges of pairs of the accessory circuit mounting plates. Air having a high temperature passing through the cooling radiators is guided by means of the accessory circuit mounting plates, and rises in the space sections.

In JP-A-2001-332 883, an on-vehicle cooling device with no refrigerant is provided, comprising a heat sink where several plate-like fins are fixed to a base bottom in parallel with constant intervals. In order that air flow at traveling passes through gaps between plate-like fins for cooling, the parallel plate-like fins are provided in parallel to the travel direction of a train while a heating body is fitted to a surface opposite to a surface of a heat sink base bottom where the plate-like fins are fixed.

### DISCLOSURE OF THE INVENTION

### PROBLEMS TO BE SOLVED BY THE INVENTION

The aforementioned conventional moving body cooling apparatus has had a problem that it has been impossible to obtain a sufficient amount of airflow from the traveling wind flowing between the cooling fins due to pressure loss caused by friction with the flat-shaped fins, for example, resulting in a reduction in cooling performance.
There has also been a problem that the temperature of the traveling wind would increase as a result of heat exchange performed on an upstream side, thereby causing a reduction in cooling ability of the flat-shaped fins on a downstream side. There is a possibility that a temperature-sensitive protective device for a downstream-side semiconductor device trips if the cooling ability of the flat-shaped fins on the downstream side drops.

To prevent tripping of the temperature-sensitive protective device, it would be necessary to increase the surface area of the cooling fins, and thus the volumetric capacity of a cooling unit, to increase thermal capacity thereof for achieving a satisfactory cooling ability. This approach has had such problems as an increase in weight, increase in cost, and so on.

The present invention has been made to overcome the aforementioned problems. Accordingly, it is an object of the invention to provide a moving body cooling apparatus which can improve cooling performance through efficient use of traveling wind produced as a moving body is running.

### MEANS FOR SOLVING THE PROBLEMS

A moving body cooling apparatus according to the present invention is intended to be installed on a moving body, the moving body cooling apparatus including a heat sink which is provided with a heat-generating element mounting portion on which a heat-generating element to be cooled is mounted, and a cooling fin block formed integrally with the heat-generating element mounting portion, the cooling fin block having a plurality of cooling fins which form grooves extending in a direction inclined from a moving direction of the moving body, the cooling fin block has slots which divide the grooves in directions parallel to and perpendicular to the moving direction of the moving body.

### ADVANTAGEOUS EFFECTS OF THE INVENTION

The moving body cooling apparatus of the present invention is intended to be installed on a moving body. Since the moving body cooling apparatus includes a heat sink which is provided with a heat-generating element mounting portion on which a heat-generating element to be cooled is mounted, and a cooling fin block formed integrally with the heat-generating element mounting portion, the cooling fin block having a plurality of cooling fins which form grooves extending in a direction inclined from a moving direction of the moving body, the length of the grooves becomes shorter,
pressure loss due to passage of wind decreases, and flow rate of the wind increases. Also, the amount of heat to be removed from the flat-shaped fins on both sides of each groove decreases. Therefore, temperature increase in traveling wind is reduced and cooling performance is improved.

### BRIEF DESCRIPTION OF THE DRAWINGS

- FIG. 1: is an explanatory diagram showing an on-board cooling apparatus that does not fall within the scope of the claims.
- FIG. 2: is a structural diagram showing the detailed structure of a heat sink of the on-board cooling apparatus that does not fall within the scope of the claims.
- FIG. 3: is a structural diagram showing a heat sink of an on-board cooling apparatus according to a first embodiment of the present invention.
- FIG. 4: is a structural diagram showing a heat sink of an on-board cooling apparatus according to a second embodiment of the present invention.
- FIG. 5: is a structural diagram showing a heat sink unit of an on-board cooling apparatus according to a fourth arrangement that does not fall within the scope of the claims.
- FIG. 6: is a structural diagram showing a heat sink unit of an on-board cooling apparatus according to a fifth arrangement that does not fall within the scope of the claims.
- FIG. 7: is a structural diagram showing a heat sink of an on-board cooling apparatus according to a sixth arrangement that does not fall within the scope of the claims.
- FIG. 8: is a structural diagram showing a heat sink of an on-board cooling apparatus according to a seventh arrangement that does not fall within the scope of the claims.

### BEST MODES FOR CARRYING OUT THE INVENTION

### FIRST ARRANGEMENT

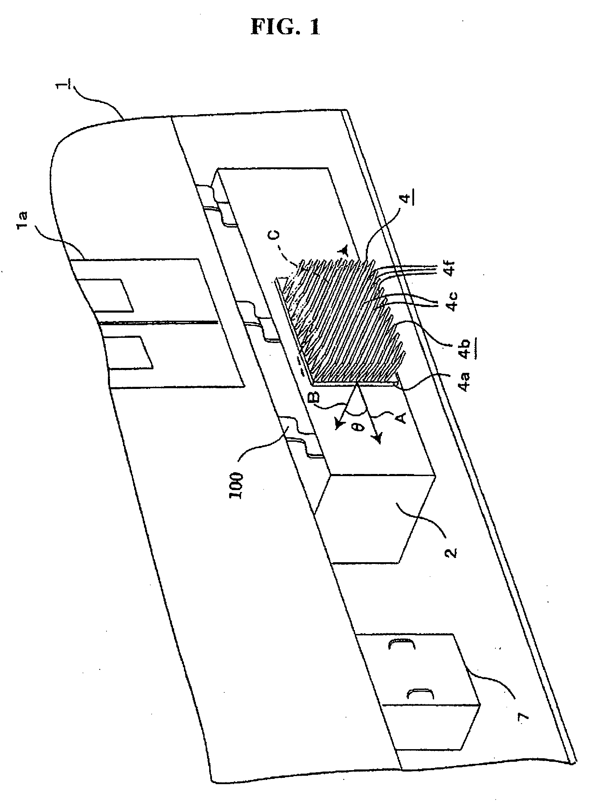

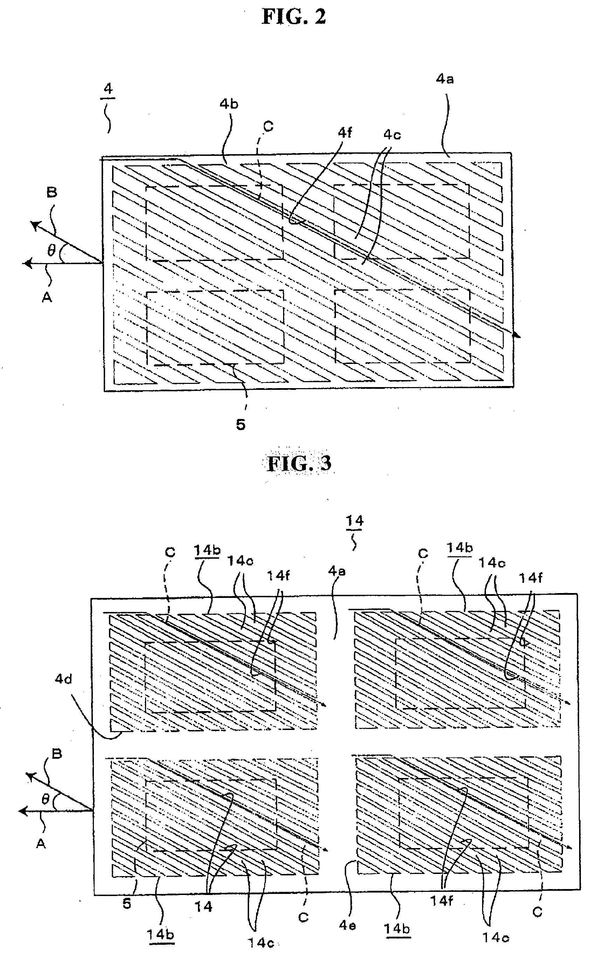

FIGS. 1 and 2 show a first arrangement for carrying out the present invention that does not fall within the scope of the claims, in which FIG. 1 is an explanatory diagram showing an on-board cooling apparatus serving as a moving body cooling apparatus mounted on a vehicle, and FIG. 2 is a structural diagram showing the detailed structure of a heat sink of the on-board cooling apparatus. As shown in FIG. 1, an electrical equipment box 2 is mounted on the bottom of a floor of a railroad car body 1 which is an example of a moving body provided with a door 1a by means of mounting metal parts 100. The heat sink 4 is affixed to a side surface of the electrical equipment box 2. Also mounted on the floor bottom of the car body 1 is another electrical equipment box 7.

The heat sink 4 has a flat-shaped base portion 4a and a cooling fin block 4b which is formed integrally with the base portion 4a. The cooling fin block 4b is configured with parallel, flat-shaped cooling fins 4c which are arranged to make a specific angle θ (FIG. 2) with a moving direction **A** of the car body 1, the flat-shaped cooling fins 4c forming grooves 4f through which traveling wind that is an airflow produced as a result of movement of the car body 1 flows (as will be discussed later in detail).

In this embodiment, four semiconductor devices 5, which are heat sources that generate heat to be dissipated, are firmly fixed to the base portion 4a. In this structure, the grooves 4f formed by the flat-shaped cooling fins 4c are arranged in such a manner that the grooves 4f run in a direction **B** forming an oblique angle of θ (30° in this example) with respect to the moving direction **A** of the car body 1.

As the direction of the grooves 4f formed by the flat-shaped cooling fins 4c is inclined with respect to the moving direction **A** of the car body 1 in the aforementioned fashion, the traveling wind flowing into the grooves 4f passes through the grooves 4f as shown by an arrow **C** in FIG. 2.

Heat generated by the semiconductor devices 5 is conducted from the base portion 4a of the heat sink 4 to the flat-shaped cooling fins 4c and a heat exchange process is performed between the flat-shaped cooling fins 4c and the traveling wind which has flowed into the grooves 4f formed between the flat-shaped cooling fins 4c. Consequently, the semiconductor devices 5 are cooled as the heat is dissipated. It is to be noted that upstream and downstream sides are reversed when the car body 1 moves in a reverse direction.

As the flat-shaped cooling fins 4c are so arranged that the direction **B** of the flat-shaped cooling fins 4c is oblique to the moving direction **A** of the car body 1, the length of the grooves 4f becomes shorter and pressure loss decreases. As a consequence, flow rate of the traveling wind (cooling wind) passing through the grooves 4f increases and the fresh traveling wind flowing along side surfaces of the flat-shaped cooling fins 4c can be taken in down to the downstream side of the heat sink 4, making it possible to improve cooling performance.

Additionally, this structure helps to alleviate the problem concerning the reduction in cooling ability on the downstream side of a conventional heat sink due to a temperature increase in the traveling wind occurring as a result of heat exchange between the flat-shaped cooling fins 4c and the traveling wind on the upstream side. It is therefore possible to improve the cooling performance and achieve a reduction in size and weight of the heat sink.

While, in the foregoing discussion and FIGS. 1 and 2, the grooves 4f formed by the flat-shaped cooling fins 4c have been illustrated as being arranged parallel to a direction from an upper-left side of the electrical equipment box 2 to a lower-right side thereof, in which the traveling wind flows, orientation of the grooves 4f is not limited to this direction.

For example, the grooves 4f may be oriented along a direction from a lower-left side of the electrical equipment box 2 to an upper-right side thereof, and the angle θ formed between the moving direction **A** of the car body 1 and the grooves 4f may be determined as appropriate. Furthermore, the base portion 4a and the cooling fin block 4b need not be formed as a single piece. Instead, the base portion 4a and the cooling fin block 4b may be separately manufactured and firmly joined together so that a specific level of thermal conductivity is obtained between both of them.

### FIRST EMBODIMENT

FIG. 3 is a structural diagram showing a heat sink of an on-board cooling apparatus according to a first embodiment of the present invention. The heat sink shown in FIG. 3 is affixed to the side surface of the electrical equipment box 2 shown in FIG. 1 in the same way as the heat sink 4 of the first embodiment. As shown in FIG. 3, the heat sink 14 has a base portion 4a and four cooling fin blocks 14b placed on the base portion 4a with specific spacings between the individual cooling fin blocks 14b.

This heat sink 14 is shaped as if the cooling fin block 4b of FIG. 2 is divided into the four cooling fin blocks 14b by providing cross-shaped slots 4d, 4e running in directions parallel to and perpendicular to the moving direction of the moving body 1 for passing the traveling wind. An average length of flat-shaped cooling fins 14c is 45 % that of the flat-shaped cooling fins 4c, the distance between the individual flat-shaped cooling fins 14c is the same as that between the flat-shaped cooling fins 4c, and the width of grooves 14f is the same as that of the grooves 4f in the heat sink 4 of FIG. 2.

While a total surface area of the flat-shaped cooling fins 14c of the four cooling fin blocks 14b is approximately 81 % that of the flat-shaped cooling fins 4c of FIG. 2, it is possible to achieve almost the same level of cooling performance. This will be discussed later in detail. Four semiconductor devices 5 are firmly affixed to the base portion 4a on opposite sides of the cooling fin blocks 14b with centers of the four semiconductor devices 5 matched with centers of the individual cooling fin blocks 14b. The heat sink 14 of this kind is manufactured by precision casting of an aluminum alloy, for example.

Next, the working is described. Heat generated by the semiconductor devices 5 is conducted from the base portion 4a of the heat sink 14 to the flat-shaped cooling fins 14c which are formed integrally with the base portion 4a and a heat exchange process is performed between the flat-shaped cooling fins 14c and the traveling wind which has flowed into the grooves 14f, so that the semiconductor devices 5 are cooled. If the heat sink 14 is shaped as if the cooling fin block 4b of FIG. 2 is divided into the four cooling fin blocks 14b with the provision of the slots 4d, 4e which permit passage of the traveling wind in the aforementioned fashion, the average length of the grooves 14f becomes 45 % that of the grooves 4f.

Consequently, the pressure loss occurring when the traveling wind passes through the grooves 14f decreases and the flow rate of the traveling wind increases, resulting eventually in an improvement in cooling efficiency. The cooling fin blocks 14b are shaped as if divided into two (upper and lower) parts (four parts in total) by the slot 4d which is parallel to the moving direction of the car body 1, or an inflow direction of the traveling wind.

Accordingly, if the same amount of heat is to be deprived of by the cooling fin blocks 14b as by the cooling fin block 4b of FIG. 2, the temperature increase in the traveling wind would be halved at outlets of the grooves 14f. It is therefore possible to perform an efficient heat exchange even on the downstream side of the flat-shaped cooling fins 14c. This structure ensures the same level of cooling performance as achieved with the flat-shaped cooling fins 4c even though the flat-shaped cooling fins 14c have a smaller surface area, making it possible to achieve a further reduction in size and weight of the heat sink 14.

### SECOND EMBODIMENT

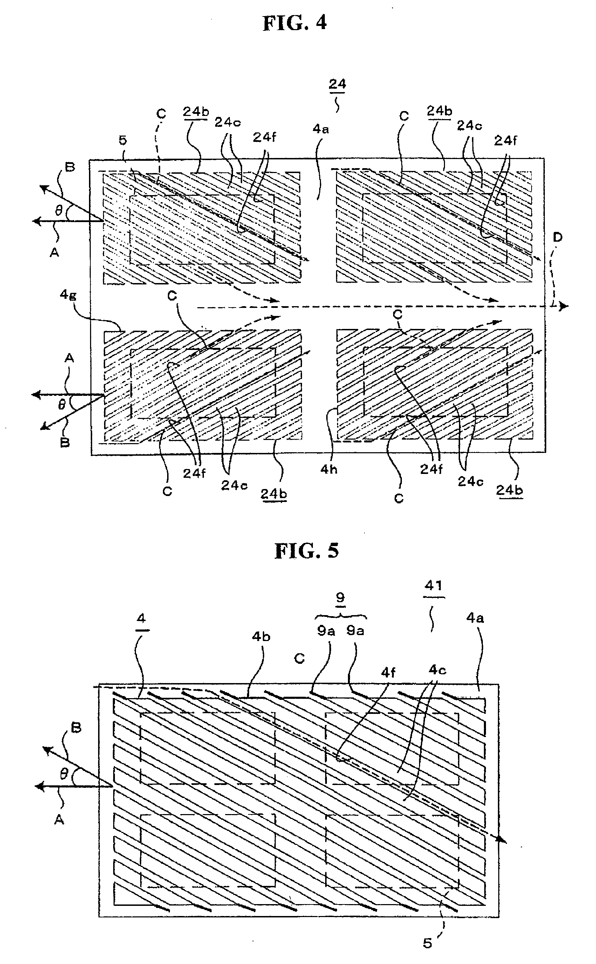

FIG. 4 is a structural diagram showing a heat sink of an on-board cooling apparatus according to a second embodiment of the present invention. As shown in FIG. 4, the heat sink 24 has a base portion 4a and four cooling fin blocks 24b separated by slots 4g, 4h provided to run in directions parallel to and perpendicular to the moving direction of the car body 1, respectively. In this heat sink 24, the cooling fin blocks 24b are structured such that the direction of grooves 24f formed by flat-shaped cooling fins 24c of the lower two cooling fin blocks 24b of FIG. 3 and the direction of grooves 24f formed by flat-shaped cooling fins 24c of the upper cooling fin blocks 24b are bilaterally symmetrical with respect to the slot 4g.

While the width of the slot 4g, or the distance between the cooling fin blocks 24b in an up-down direction, is made larger than the width of the slot 4h by a specific amount, the distances between these four cooling fin blocks 24b in the up-down and left-right directions may be determined as appropriate depending on the size of the cooling fin blocks 24b.

Since the heat sink 24 has otherwise the same structure as the first embodiment shown in FIG. 3, corresponding elements are designated by the same reference symbols and a description of such elements is not given below. The heat sink 24 of this kind is manufactured by precision casting of an aluminum alloy, for example.

In this heat sink 24, traveling wind streams flow into the heat sink 24 from both upper and lower sides thereof as shown by arrows **C** in FIG. 4 and combine into a single airflow in the middle of the slot 4g, and this combined airflow flows out from a right end of the heat sink 24 as shown by an arrow **D**. In this embodiment, the traveling wind streams which flow out from the upper cooling fin blocks 24b and the traveling wind streams which flow out from the lower cooling fin blocks 24b are combined into the single airflow and ejected.

It is therefore possible to prevent the traveling wind streams which have flowed out from the upper cooling fin blocks 24b from mixedly flowing into the lower cooling fin blocks 24b, so that the cooling performance can be further improved. While the traveling wind flows in an opposite direction when the moving direction of the car body 1 is reversed, the heat sink 24 produces the same operational and working effects.

While the base portion 4a is configured with a single plate in the second and third embodiments described above, the embodiments may be modified such that the base portion 4a is divided into four parts depending on the number of the semiconductor devices 5 to be mounted and the cooling fin blocks 14b, 24b are provided separately on the four divided parts of the base portion.

### FOURTH ARRANGEMENT

FIG. 5 is a structural diagram showing a heat sink unit of an on-board cooling apparatus according to a fourth arrangement that does not fall within the scope of the claims. The heat sink unit shown in FIG. 5 is affixed to the side surface of the electrical equipment box 2 shown in FIG. 1 in the same way as the heat sink 4 of the first arrangement. As shown in FIG. 5, the heat sink unit 41 is structured as if the heat sink 4 shown in FIG. 2 is provided with a louver 9. The louver 9 has rectangular, thin platelike slats 9a which are disposed to project from ends of the individual flat-shaped cooling fins 4c on lines extending therefrom at an upper peripheral part of the cooling fin block 4b. All of the slats 9a have the same dimensions.

Next, the working is described. Heat generated by the semiconductor devices 5 is conducted from the base portion 4a of the heat sink 4 to the flat-shaped cooling fins 4c and a heat exchange process is performed between the flat-shaped cooling fins 4c and the traveling wind which has flowed into the grooves 4f formed between the flat-shaped cooling fins 4c. As a consequence, the semiconductor devices 5 are cooled.

Due to the provision of the louver 9, it is possible to forcibly draw traveling wind streams which have passed through areas separated from the flat-shaped cooling fins 4c into the grooves 4f between the flat-shaped cooling fins 4c. Therefore, the traveling wind can be introduced in larger quantities, thus achieving an increased cooling ability.

### FIFTH ARRANGEMENT

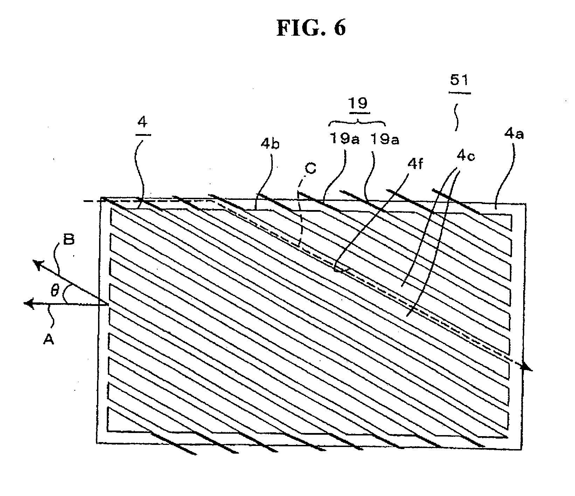

FIG. 6 is a structural diagram showing a heat sink unit of an on-board cooling apparatus according to a fifth arrangement that does not fall within the scope of the claims. As shown in FIG. 6, the heat sink unit 51 is structured as if the heat sink 4 shown in FIG. 2 is provided with a louver 19. The louver 19 has rectangular, thin platelike slats 19a which are disposed to project from ends of the individual flat-shaped cooling fins 4c on lines extending therefrom at an upper peripheral part of the cooling fin block 4b. The length of projection of the slats 19a provided on the upper end of the cooling fin block 4b gradually increases downstream along the direction of the traveling wind, while the length of projection of the slats 19a provided on the lower end of the cooling fin block 4b gradually decreases downstream along the direction of the traveling wind.

While all of the slats 9a are structured to project in the extending direction of the flat-shaped cooling fins 4c by a specific length in the fourth arrangement shown in FIG. 5, the traveling wind streams are improved, producing a greater wind drawing effect, if the length of projection of the slats 9a is gradually varied along the direction from the flat-shaped cooling fins 4c located at the upstream side toward those located at the downstream side.

### SIXTH ARRANGEMENT

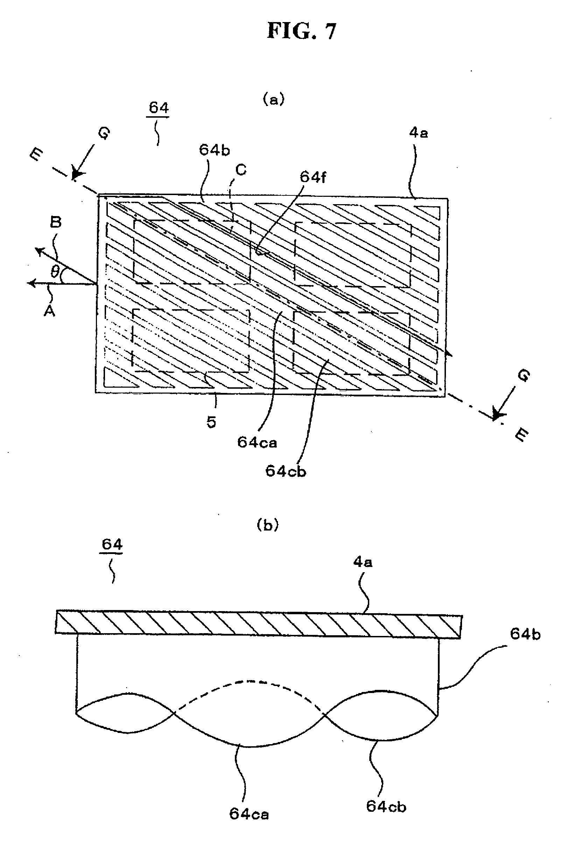

FIG. 7 is a structural diagram showing a heat sink of an on-board cooling apparatus according to a sixth arrangement that does not fall within the scope of the claims, FIG. 7(a) being a plan view of the heat sink and FIG. 7(b) being a sectional view showing a cross section taken along lines E-E as seen from a direction of arrows **G**. It is to be noted that semiconductor devices 5 are not shown in FIG. 7(b). As shown in FIG. 7, the heat sink 64 has a base portion 4a and a cooling fin block 64b which is formed integrally with the base portion 4a.

The cooling fin block 64b has flat-shaped cooling fins 64ca and flat-shaped cooling fins 64cb of which height from the base portion 4a is varied in a sinusoidal pattern along a longitudinal direction as seen in side view, wherein the flat-shaped

cooling fins 64ca and 64cb are alternately arranged in a manner that crests and troughs of the flat-shaped cooling fins 64cb and those of the flat-shaped cooling fins 64ca are located opposite each other as depicted in FIG. 7(b).

The flat-shaped cooling fins 64ca and 64cb together form grooves 64f in between. Since the heat sink 64 has otherwise the same structure as the first arrangement shown in FIG. 2, corresponding elements are designated by the same reference symbols and a description of such elements is not given below.

Due to the provision of the flat-shaped cooling fins 64ca, 64cb having alternately varied shapes, it is possible to enhance the effect of drawing wind streams into the grooves 64f so that a larger quantity of traveling wind passes through the grooves 64f, thus producing an improved cooling effect.

### SEVENTH ARRANGEMENT

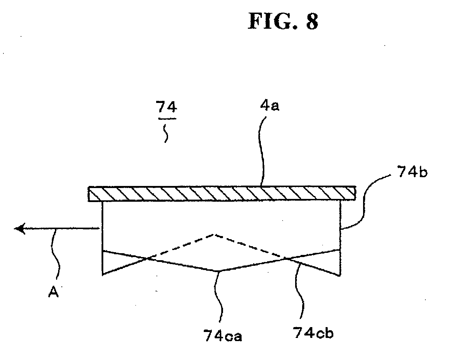

FIG. 8 is a sectional side view of a heat sink of an on-board cooling apparatus according to a seventh arrangement that does not fall within the scope of the claims. It is to be noted that semiconductor devices 5 are not shown in FIG. 8. As shown in FIG. 8, the heat sink 74 has a base portion 4a and a cooling fin block 74b which is formed integrally with the base portion 4a. The height of flat-shaped cooling fins 74ca of the cooling fin block 74b is varied in a sawtooth pattern along a longitudinal direction as seen in side view as depicted in FIG. 8.

The height of flat-shaped cooling fins 74cb is varied such that crests and valleys of the flat-shaped cooling fins 74ca and those of the flat-shaped cooling fins 74cb are located opposite each other. The cooling fin block 74b is configured with these flat-shaped cooling fins 74ca, 74cb alternately arranged. The flat-shaped cooling fins 74ca, 74cb together form grooves 74f in between. Since the heat sink 74 has otherwise the same structure as the first arrangement shown in FIG. 2, corresponding elements are designated by the same reference symbols and a description of such elements is not given below.

Due to the provision of the flat-shaped cooling fins 74ca, 74cb having alternately varied shapes, it is possible to enhance the effect of drawing wind streams into the grooves 74f so that a larger quantity of traveling wind passes through the grooves 74f, thus producing an improved cooling effect.

While the foregoing discussion of the individual embodiments has dealt with a case where the moving body is a body of a railroad car, the invention produces the same effect even when the moving body is a motor vehicle or a moving body of other kinds.

## Claims

1. A moving body cooling apparatus which is installed on a moving body (1), the moving body cooling apparatus comprising:
- a heat-generating element mounting portion (4a) on which a heat-generating element (5) to be cooled is mounted; and
- a cooling fin block (14b, 24b) formed integrally with the heat-generating element mounting portion (4a), the cooling fin block (14b, 24b) having a plurality of cooling fins (14c, 24c) which form grooves (14f, 24f) extending in a direction inclined from a moving direction of the moving body (1);
**characterized in that**:
- the cooling fin block (14b, 24b) has slots (4d, 4e, 4g, 4h) which divide the grooves (14f, 24f) in directions parallel to and perpendicular to the moving direction of the moving body (1).

2. The cooling apparatus as recited in claim 1,
wherein the cooling fin block (24b) has the slot (4g) running in the direction parallel to the moving direction of the moving body (1), and
wherein the plurality of cooling fins (24c) form the grooves (24f) in such a manner that the grooves (24f) are oppositely inclined with respect to the slot (4g) running in the direction parallel to the moving direction of the moving body (1).

3. The cooling apparatus as recited in claim 1 or 2,
wherein a wind drawing member (9a) projecting from the cooling fins (14c, 24c) in a direction extending from the grooves (14f, 24f) is provided.

4. The cooling apparatus as recited in anyone of claims 1 to 2,
wherein the height of the cooling fins (14c, 24c) from the heat-generating element mounting portion (4a) is varied along a longitudinal direction of the grooves (14f, 24f).

5. The cooling apparatus as recited in anyone of claims 1 to 4,
wherein the grooves (14f, 24f) have a first width,
and the slots (4d, 4e, 4g, 4h) have a second width greater than the first width.

## Patentansprüche

1. Kühlvorrichtung für einen sich bewegenden Körper (1), die an einem sich bewegenden Körper (1) angebracht ist, wobei die Kühlvorrichtung für den sich bewegenden Körper Folgendes aufweist:
- einen Befestigungsbereich (4a) für ein Wärmeerzeugungselement (5), an dem ein zu kühlendes Wärmeerzeugungselement angebracht ist; und
- einen Kühlrippenblock (14b, 24b), der integral mit dem Wärmeerzeugungselement-Befestigungsbereich (4a) ausgebildet ist, wobei der Kühlrippenblock (14a, 14b) eine Vielzahl von Kühlrippen (14c, 24c) aufweist, die Nuten (14f, 24f) bilden, die in einer zu einer Bewegungsrichtung des sich bewegenden Körpers (1) geneigten Richtung verlaufen;
**dadurch gekennzeichnet,**
- **dass** der Kühlrippenblock (14b, 24b) Schlitze (4d, 4e, 4g, 4h) aufweist, die die Nuten (14f, 24f) in Richtungen parallel zu und senkrecht zu der Bewegungsrichtung des sich bewegenden Körpers (1) unterteilen.

2. Kühlvorrichtung nach Anspruch 1,
wobei der Kühlrippenblock (24b) den Schlitz (4g) in einer parallel zu der Bewegungsrichtung des sich bewegenden Körpers (1) verlaufenden Richtung aufweist, und
wobei die Vielzahl von Kühlrippen (24c) die Nuten (24f) derart bilden, dass die Nuten (24f) in Bezug auf den Schlitz (4g), der parallel zu der Bewegungsrichtung des sich bewegenden Körpers (1) verläuft, in entgegengesetzten Richtungen geneigt sind

3. Kühlvorrichtung nach Anspruch 1 oder 2,
wobei ein Strömungseinziehelement (9a) vorgesehen ist, das von den Kühlrippen (14c, 24c) in einer von den Nuten (14f, 24f) weg verlaufenden Richtung vorsteht.

4. Kühlvorrichtung nach einem der Ansprüche 1 bis 2,
wobei die Höhe der Kühlrippen (14c, 24c) von dem Wärmeerzeugungselement-Befestigungsbereich (4a) entlang einer Längsrichtung der Nuten (14f, 24f) variiert.

5. Kühlvorrichtung nach einem der Ansprüche 1 bis 4,
wobei die Nuten (14f, 24f) eine erste Breite aufweisen und die Schlitze (4d, 4e, 4g, 4h) eine zweite Breite aufweisen, die größer ist als die erste Breite.

## Revendications

1. Appareil de refroidissement de corps mobile qui est installé sur un corps mobile (1), l'appareil de refroidissement de corps mobile comprenant :
- une portion de montage (4a) pour élément générateur de chaleur, sur laquelle est monté un élément générateur de chaleur (3) à refroidir; et
- un bloc d'ailettes de refroidissement (14b, 24b) formé intégralement avec la portion de montage (4a) pour élément générateur de chaleur, le bloc d'ailettes de refroidissement (14b, 24b) ayant une pluralité d'ailettes de refroidissement (14c, 24c) qui forment des gorges (14f, 24f) s'étendant dans une direction inclinée depuis une direction de déplacement du corps mobile (1);
**caractérisé en ce que** :
- le bloc d'ailettes de refroidissement (14b, 24b) comprend des fentes (4d, 4e, 4g, 4h) qui divisent les gorges (14f, 24f) dans des directions parallèles et perpendiculaires à la direction de déplacement du corps mobile (1).

2. Appareil de refroidissement selon la revendication 1,
dans lequel le bloc d'ailettes de refroidissement (24b) est tel que la fente (4g) s'étend dans la direction parallèle à la direction de déplacement du corps mobile (1), et
dans lequel la pluralité d'ailettes de refroidissement (24c) forment les gorges (24f) d'une telle manière que les gorges (24f) sont inclinées de manière opposée par rapport à la fente (4g) s'étendant dans la direction parallèle à la direction de déplacement du corps mobile (1).

3. Appareil de refroidissement selon la revendication 1 ou 2,
dans lequel il est prévu un élément de captage de vent (9a) qui se projette depuis les ailettes de refroidissement (14c, 24c) dans une direction s'étendant depuis les gorges (14f, 24f).

4. Appareil de refroidissement selon l'une quelconque des revendications 1 et 2,
dans lequel la hauteur des ailettes de refroidissement (14c, 24c) depuis la portion de montage (4a) pour élément générateur de chaleur varie le long d'une direction longitudinale des gorges (14f, 24f).

5. Appareil de refroidissement selon l'une quelconque des revendications 1 à 4,
dans lequel les gorges (14f, 24f) ont une première largeur, et les fentes (4d, 4e, 4g, 4h) ont une seconde largeur supérieure à la première largeur.
